# EUROPEAN PATENT APPLICATION

(11) **EP 3 541 159 A1**
(43) Date of publication of application: **18.09.2019**
(21) Application number: 19161838.8
(22) Date of filing: 11.03.2019
(51) Int. Cl.: H05K 7/20

(54) **FLEXIBLE HEAT SINK FOR AIRCRAFT ELECTRONIC UNITS**

(30) Priority: 13.03.2018 IN 201811009191
(71) Applicant: ROSEMOUNT AEROSPACE INC., Burnsville, MN 55306-4898 (US)
(72) Inventor: PALLE, John Sunil Kumar, 560066 Bengaluru (IN)
(74) Representative: Dehns

(57) **Abstract**

One or more embodiments of the invention include a heat sink device, system and method for removing heat from aircraft electronics including a chassis (206; 320), an electronic unit (302), wherein the electronic unit (302) is thermally coupled to the chassis (206; 320), and a thermally conductive member, wherein the thermally conductive member includes a first interface (204) for thermally contacting an electronic unit (302) and a second interface (206) for thermally contacting the chassis (206; 320), the thermally conductive member being flexible in at least one direction between the first interface (204) and the second interface (206) to reduce load imparted on the electronic unit (302) by the thermally conductive member in comparison to if the thermally conductive member were not flexible.

## Description

### CROSS-REFERENCE TO RELATED APPLICATIONS

This application claims the benefit of Indian Application No. 201811009191 filed March 13, 2018, which is incorporated herein by reference in its entirety.

### BACKGROUND

The present disclosure relates generally to thermal management systems, and more particularly, to flexible heat sinks for electronic units, such as those used on aircrafts and other vehicles.

Powerful electronics devices generate large amounts of heat during operation. In addition, these electronics are provided in close proximity to other devices that generate heat. As technology advances, devices are becoming more compact which makes removing heat from the device even more critical to ensure the proper functioning of the device.

Heat sinks and other thermal management devices are used to remove excessive and unwanted heat from the enclosed housing containing the electronics. Various types of heat sinks include passive and active thermal management systems. Active thermal management systems use forced air, liquid or heat pumps to remove heat. Passive thermal management systems generally dissipate heat through structures such as heat sinks without the use of an external device to remove the heat.

### BRIEF DESCRIPTION

According to one embodiment, a heat sink for aircraft electronics including a thermally conductive member with a first interface for thermally contacting an electronic unit and a second interface for thermally contacting a chassis, the thermally conductive member being flexible in at least one direction between the first interface and the second interface to reduce loads imparted on the electronic unit by the thermally conductive member in comparison to if the thermally conductive member were not flexible is provided.

In addition to one or more of the features described above, or as an alternative, further embodiments may include wherein the thermally conductive member is a honeycomb structure.

In addition to one or more of the features described above, or as an alternative, further embodiments may include wherein the thermally conductive member is composed of aluminum or magnesium and/or alloy thereof.

In addition to one or more of the features described above, or as an alternative, further embodiments may include wherein the thermally conductive member is coupled to the electronic unit and the chassis using a thermal paste.

In addition to one or more of the features described above, or as an alternative, further embodiments may include wherein the thermally conductive member is a flexible heat sink.

In addition to one or more of the features described above, or as an alternative, further embodiments may include wherein the thermally conductive member is a passive thermal management device.

In addition to one or more of the features described above, or as an alternative, further embodiments may include wherein the thermally conductive member is disposed in an aircraft.

In addition to one or more of the features described above, or as an alternative, further embodiments may include wherein the thermally conductive member is incorporated in an electronics box.

In addition to one or more of the features described above, or as an alternative, further embodiments may include wherein the thermally conductive member is disposed in a heat sink system including the chassis and the electronic unit, wherein the electronic unit is thermally coupled to the chassis.

According to another embodiment, a method for removing heat from an electronic unit of an aircraft, includes coupling a first interface of a thermally conductive member to an electronic unit, coupling a second interface of the thermally conductive member to a chassis, and elastically deforming the thermally conductive member between the first interface and the second interface in response to relative movement between a portion of the electronic unit in contact with the first interface and a portion of the chassis in contact with second interface is provided.

In addition to one or more of the features described above, or as an alternative, further embodiments may further include arranging the thermally conductive member in a housing.

In addition to one or more of the features described above, or as an alternative, further embodiments may include wherein the thermally conductive member is a honeycomb structure.

In addition to one or more of the features described above, or as an alternative, further embodiments may include wherein the thermally conductive member is composed of aluminum or magnesium and/or an alloy thereof.

In addition to one or more of the features described above, or as an alternative, further embodiments may include disposing a thermal paste between the first interface of the thermally conductive member and the electronic unit and between the second interface and the thermally conductive member.

In addition to one or more of the features described above, or as an alternative, further embodiments may include wherein the thermally conductive member is disposed in an aircraft.

### BRIEF DESCRIPTION OF THE DRAWINGS

The subject matter which is regarded as the present disclosure is particularly pointed out and distinctly claimed in the claims at the conclusion of the specification. The foregoing and other features, and advantages of the present disclosure are apparent from the following detailed description taken in conjunction with the accompanying drawings in which:
FIG. 1 depicts a heat sink in a heat sink system;
FIG. 2 depicts a flexible heat sink for electronic units in accordance with one or more embodiments of the invention;
FIG. 3 depicts a flexible heat sink system for electronic units in accordance with one or more embodiments of the invention; and
FIG. 4 depicts a flow chart for removing heat from an electronic unit of an aircraft in accordance with one or more embodiments of the invention.

### DETAILED DESCRIPTION

A detailed description of one or more embodiments of the disclosed apparatus and method are presented herein by way of exemplification and not limitation with reference to the Figures. It is to be understood that other embodiments may be utilized and changes may be made without departing from the scope of the present disclosure. In particular, the disclosure provides various examples related to flexible heat sinks for aircraft electronic units, whereas the advantages of the present disclosure as applied in a related field would be apparent to one having ordinary skill in the art and are considered to be within the scope of the resent invention. The techniques described herein remove the rigid attachments on the heat generating electronics unit to avoid solder joint cracks leading to failure of the device.

The rigid heat sinks can lead to solder joint failures as the solder joints are the weak links. In case of any structural loads caused due to vibrations or thermal expansion, the deflection of electronic unit or power supply unit is hindered by the rigid heat sink causing the solder joints to become stressed and eventually crack. For example, a power supply unit is mounted on a printed circuit board (PCB) by soldering its pins to the PCB. The rigid heat sink is mounted on top of the power supply unit where the other end is connected to chassis. In the event of a thermal cycling load or vibrational load occurring during normal operation, the solder joints can begin to crack as the rigid heat sink prevents the deflection of power supply unit leading to failure in the devices. In the absence of an effective heat sink, the power supply unit can become overheated beyond its allowable operational limit rendering the unit non-functional.

The techniques and devices described herein relieve the components from thermal and assembly stress due to the excess heat generated during normal operation by using a flexible heat sink. In one or more embodiments of the invention, the thermal reduction in temperature is approximately 30 degree C. For example, the flexible heat sink can be implemented in an electronics box such as but not limited to a proximity sensing electronic unit (PSEU) for BD100 applications.

Use of flexible heat sinks provides sufficient flexibility to absorb deflection due to assembly, vibration loads and thermal expansion. In addition, the heat sink design can use various honeycomb configurations and materials to optimize heat absorption and removal. One or more embodiments of the invention include attaching the flexible heat sink to rig circuit component assembly (CCA) and electronic control unit (ECU) assembly.

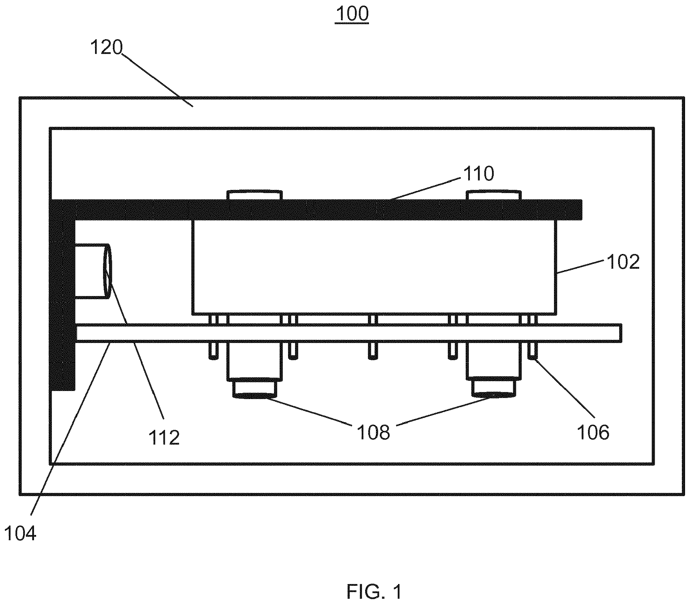

Now referring to FIG. 1, a configuration 100 of a heat sink is shown. The configuration 100 includes a power supply unit 102 and printed circuit board (PCB) 104. The PCB 104 can include a plurality of solder joints 106 for coupling the power supply unit 102 to the PCB 104. The system 100 also includes a rigid heat sink 110 that is coupled to the power supply 102 and a portion of the housing 120. The PCB 104 can also include multiple screws or bolts 108 to securely connect the heat sink 110 to the power supply unit 102 to efficiently remove the heat from within the housing 120 and power supply unit 102. The heat sink 110 can be secured to the housing 120 using one or more bolts 112.

During normal operation, the power supply unit is subjected to vibration loads and thermal loads. This causes the power supply unit to deflect and expand, but the rigid heat sink 110 mounted on it does not allow the power supply to deflect as the other end of the heat sink is firmly connected to chassis. Stress is generated on the power supply unit as its free movement is blocked. This stress is transmitted to the solder joint location. Since the solder joint is the weakest link of the system, it cracks due to the stress. The cracks in the solder joint eventually lead to operational failure of the unit.

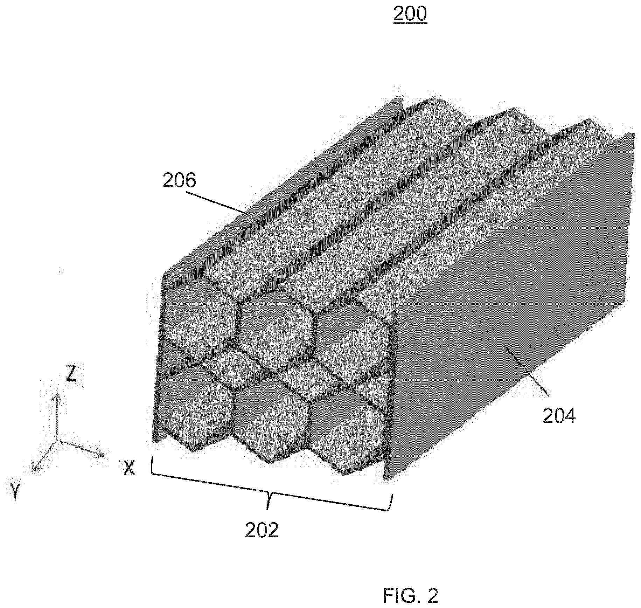

Now referring to FIG. 2, a diagram 200 of a flexible heat sink 202 in accordance with one or more embodiments of the invention is shown.

The flexible heat sink 202 or thermal conductive member includes a first thermal interface 204 and a second thermal interface 206. In one or more embodiments of the invention, the first thermal interface 204 can be coupled to a heat generating electronic unit to remove the heat and the second thermal interface can be coupled to a chassis/housing 206 to provide a path for the transfer of heat. Also, the contact between the flexible heat sink 202, the electronic unit and chassis can be improved by using a thermal paste or adhesive to increase the heat transfer and removal. The contact is improved by filling in the air gaps and space between flexible heat sink 202 and its contacting surface.

The flexible heat sink 202 absorbs the deflection due to assembly, vibration loads and thermal expansion. The flexible heat sink 202 design includes honeycomb structures made of various material options.

The honeycomb shape provides lower stiffness when compared to conventional heat sink shapes such as a flat plate. The flexible heat sink 202 design allows for expansion and contraction in both the X and Z directions as shown in FIG. 2. In one or more embodiments, the thermally conductive member is flexible in an at least one direction. The flexible heat sink 202 can be constructed of any suitable material such as aluminum or magnesium alloy that are highly conductive to aid the heat transfer from the power supply unit to the housing and then to the ambient environment, keeping the temperature below the limit. Embodiments of the invention can include utilizing a combination of aluminum or magnesium alloys. In addition, other softer alloys can be used and is considered within the scope of the invention.

In one or more embodiments of the invention, the flexible heat sink 202 can include a plurality of configurations and shapes for its design. It is to be understood the design of the flexible heat sink 202 can vary based on the needs of the application such as the length, material, thickness, etc. for optimal performance and flexibility of the heat sink 202. In one or more embodiments of the invention, the flexible heat sink 202 is used in aircraft electronic unit applications.

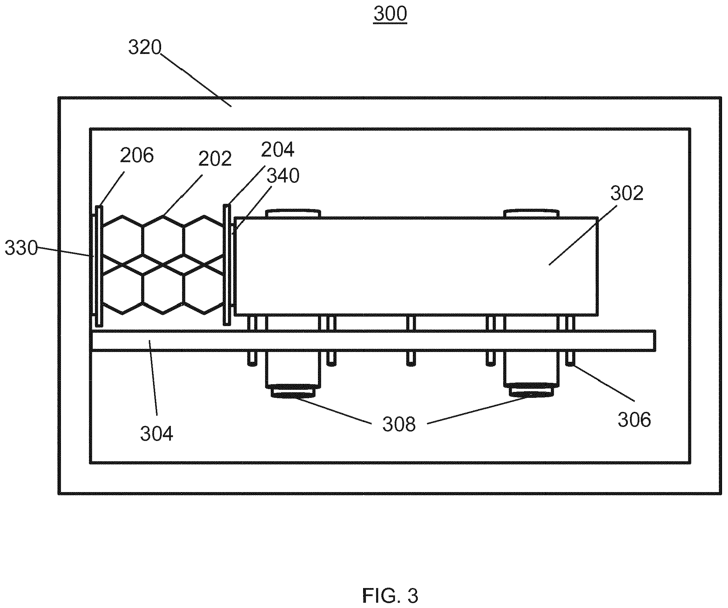

Now referring to FIG. 3, a diagram 300 for a flexible heat sink system in accordance with one or more embodiments of the invention is shown.

The flexible heat sink system includes an electronic unit 302, where the electronic unit 302 is coupled to the PCB 304. The electronic unit can include but is not limited to any heat generating electronics component such as a power supply unit or other heat source. In one or more embodiments of the invention, the PCB 304 is coupled to the electronic unit 302 by one or more solder joints 306. The flexible heat sink 202 is a thermal conductive member, having a honeycomb structure such as the flexible heat sink shown in FIG. 2. The flexible heat sink 202 is enclosed in the chassis (housing) 320. The thermal conductive member 202 is coupled to the electronic unit 302 and the housing 320.

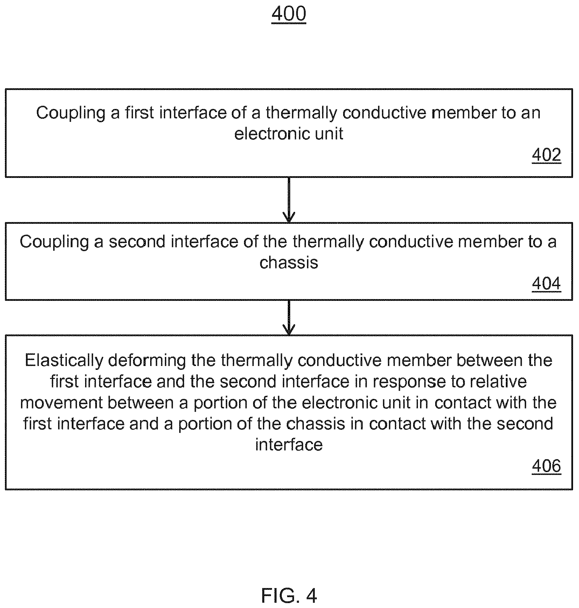

Referring now to FIG. 4, a flow chart 400 for removing heat from an electronic unit of an aircraft in accordance with one or more embodiments of the invention is shown.

Block 402 provides coupling a first interface of a thermally conductive member to an electronic unit. As shown in FIG. 3, a first interface 204 of the flexible heat sink 202 is attached to the electronic unit 302. Block 404 provides coupling a second interface of the thermally conductive member to a chassis. FIG. 3 also shows a second interface 206 is coupled to the housing/chassis 320 in the heat sink system. Block 406 provides elastically deforming the thermally conductive member between the first interface and the second interface in response to relative movement between a portion of the electronic unit in contact with the first interface and a portion of the chassis in contact with the second interface. In one or more embodiments of the invention, the flexible heat sink 202 or thermally conductive member is able to be elastically deformed in a least one direction. This configuration reduces the stress experienced at the solder joints, such as solder joints 306, when compared to other heat sinks being implemented using rigid, not flexible structures.

The technical effects and benefits of the invention include the reduction and/or elimination of overheating of electronic and power supply units. In addition, solder joint crack failure is reduced and/or eliminated. The increased reliability reduces the field failures and provides savings in repair/replacement costs.

The structural benefit is a reduction in stiffness by approximately 37% when the flexible heat sink is used instead of a conventional rigid heat sink. The honeycomb structure maximizes surface area and can make use of material that has high thermal conductivity. The passive thermal management system is cheaper than an active thermal management system.

While the present disclosure has been described in detail in connection with only a limited number of embodiments, it should be readily understood that the present disclosure is not limited to such disclosed embodiments. Rather, the present disclosure can be modified to incorporate any number of variations, alterations, substitutions or equivalent arrangements not heretofore described, but which are commensurate with the spirit and scope of the present disclosure. Additionally, while various embodiments of the present disclosure have been described, it is to be understood that aspects of the present disclosure may include only some of the described embodiments. Accordingly, the present disclosure is not to be seen as limited by the foregoing description, but is only limited by the scope of the appended claims.

## Claims

1. A heat sink for aircraft electronics comprising:
one or more solder joints coupling a board to an electronic unit;
a thermally conductive member with a first interface for thermally contacting the electronic unit and a second interface for thermally contacting a chassis, the thermally conductive member being flexible in at least two directions between the first interface and the second interface to reduce load imparted on the electronic unit by the thermally conductive member in comparison to if the thermally conductive member were not flexible, wherein the thermally conductive member is comprised of a magnesium alloy, wherein the thermally conductive member is a honeycomb structure, and wherein the thermally conductive member reduces stress at the one or more solder joints.

2. The heat sink of claim 1, wherein the thermally conductive member is coupled to the electronic unit and the chassis using a thermal paste.

3. The heat sink of claim 1 or 2, wherein the thermally conductive member is a flexible heat sink.

4. The heat sink of claim 1, 2 or 3, wherein the thermally conductive member is a passive thermal management device.

5. The heat sink of any preceding claim, wherein the thermally conductive member is disposed in an aircraft.

6. The heat sink of any preceding claim, wherein the thermally conductive member is incorporated in the electronics unit.

7. The heat sink of any preceding claim, wherein the thermally conductive member is disposed in a heat sink system including the chassis and the electronic unit, wherein the electronic unit is thermally coupled to the chassis.

8. A method for removing heat from an electronic unit of an aircraft, comprising:
coupling a board to an electronic unit using one or more solder joints;
coupling a first interface of a thermally conductive member to the electronic unit;
coupling a second interface of the thermally conductive member to a chassis; and
elastically deforming the thermally conductive member between the first interface and the second interface in at least two directions in response to relative movement between a portion of the electronic unit in contact with the first interface and a portion of the chassis in contact with second interface, wherein the thermally conductive member is comprised of a magnesium alloy, wherein the thermally conductive member is a honeycomb structure, and wherein the thermally conductive member reduces stress at the one or more solder joints.

9. The method of claim 8, further comprising arranging the thermally conductive member in a housing.

10. The method of claim 8 or 9, further comprising disposing a thermal paste between the first interface of the thermally conductive member and the electronic unit and between the second interface and the thermally conductive member.

11. The method of claim 8, 9 or 10, wherein the thermally conductive member is disposed in an aircraft.
